# EUROPEAN PATENT APPLICATION

(11) **EP 4 369 416 A1**
(43) Date of publication of application: **15.05.2024**
(21) Application number: 22206888.4
(22) Date of filing: 11.11.2022
(51) Int. Cl.: H01L 29/78, H01L 29/06, H01L 23/00

(54) **SEMICONDUCTOR DIE AND METHOD OF MANUFACTURING THE SAME**

(71) Applicant: Infineon Technologies Austria AG, 9500 Villach (AT)
(72) Inventor: MAURER, Daniel, 9544 Feld am See (AT); KONRAD, Sabine, 9500 Villach (AT); SACK, Steffen, 9500 Villach (AT); OSTERMANN, Thomas, 9231 Velden am Wörthersee (AT)
(74) Representative: König Szynka Tilmann von Renesse Patentanwälte Partnerschaft mbB München

(57) **Abstract**

The disclosure relates to a semiconductor die (1), having a semiconductor body (2) comprising an active region (3),an insulation layer (4) formed on the semiconductor body (2), wherein a p-channel device (5) is formed in the active region (3), and wherein a sodium stopper (10) is formed in the insulation layer (4) and arranged laterally between the active region (3) and a lateral edge (1.1) of the die (1), the sodium stopper (10) comprising an insulation layer groove (11), which intersects the insulation layer (4) vertically and extends around the active region (3), the insulation layer groove (11) filled with a diffusion barrier material (21).

## Description

### TECHNICAL FIELD

The present disclosure relates to a semiconductor die with a p-channel device.

### BACKGROUND

The p-channel device can for instance be a lateral FET having its source and drain region at the frontside of the semiconductor body. On the semiconductor body, an insulation layer is formed, e. g. isolating a metallization layer on top from the semiconductor body, e. g. apart from defined source and drain contacts. The source and drain region are p-doped, whereas the body region of this device is n-doped. In this body region, which in this example is arranged at the frontside laterally between the source and the drain region, a p-channel can be formed by applying a gate voltage to a gate region. The latter can comprise a gate electrode and a gate dielectric capacitively coupling the gate electrode to the body region of the lateral FET. This shall illustrate a possible p-channel device formed in the active region but not limit the scope of the claims.

### SUMMARY

It is an object of the present application to provide a semiconductor die with an improved design, as well as a method of manufacturing such a die.

This object is achieved by the semiconductor die of claim 1, and moreover it is achieved by the method of claim 14. In the insulation layer of the die, a sodium stopper made of a sodium stopper groove filled with a diffusion barrier material is provided. The sodium stopper groove intersects the insulation layer vertically and extends around the active region laterally, wherein the diffusion barrier material prevents a sodium diffusion in the insulation layer, e. g. from a lateral edge of the die towards the active region. The sodium can for instance remain from the assembly process, e. g. from flux / flux clean chemistry post die attach, or be released from the mold compound.

A sodium contamination can be critical for n-channel devices, but here it is applied in case of a p-channel device. This is because the inventors found that a sodium diffusion towards the active region with the p-channel device can create an artificial gate for a parasitic n-channel device. In other words, even though the actual device (p-channel) in the active region would be uncritical in view of the sodium diffusion, the sodium can create or trigger a parasitic n-channel device. This can for instance lead to increased leakage currents, e. g. between source and drain during high temperature reverse bias (HTRB) and/or high humidity high temperature reverse bias (H3TRB). Under the conditions applied in these reliability tests, not the active p-channel device as such but a parasitic device created or triggered by the sodium diffusion was found to be critical.

Particular embodiments and features are provided in this description and in the dependent claims. Therein, the individual features shall be disclosed independently of a specific claim category, the disclosure relates to apparatus and device aspects, but also to method and use aspects. If for instance a die manufactured in a specific way is described, this is also a disclosure of a respective manufacturing process, and vice versa. In general words, an approach of this application is to protect a p-channel device by a sodium stopper, in particular with a diffusion barrier material, from a sodium diffusion.

The sodium stopper groove intersects the insulation layer vertically, wherein the vertical direction lies for instance perpendicular to the frontside of the semiconductor body or the frontside of a semiconductor substrate of the semiconductor body. In the lateral directions, which lie perpendicular to the vertical direction, the insulation layer groove extends around the active region of the die. Seen in a vertical top view, the sodium stopper / insulation layer groove can surround the active region, in particular completely, namely over a whole circumference forming a closed line.

The p-channel device in the active region can in particular be a power device, e. g. having a breakdown voltage of at least 10V, 20V or 40V, with the possible upper limits of for instance not more than 800V, 600V, 400V, 200V or 100V. Independently of the specific voltage class, for instance only the p-channel device or only p-channel devices can be formed in the active region; in particular, the only device in the active region can be a discrete p-channel device comprising a plurality of p-channel device cells connected in parallel. As discussed previously, the device can in particular be a lateral p-channel FET having its source, drain and body region at the frontside of the semiconductor body.

Independently of the particular design in the active region, the semiconductor body can for instance comprise a semiconductor substrate (e. g. silicon), and additionally it can comprise an epitaxial layer or layers on the substrate. In the semiconductor body, e. g. in the epitaxial layer, the source region and, depending on the design, also the body and drain region of the device can be formed. The insulation layer is arranged on the semiconductor body, it can comprise an oxide, for instance silicon oxide and/or borophosphosilicate glass (BPSG). In particular, the insulation layer can be formed of stacked sublayers, for example a lower oxide layer and a BPSG layer on top.

In an embodiment, an edge termination structure is formed laterally between the active region and the lateral edge of the die, comprising an n-well in a p-region. Seen in a lateral cross-section, the sectional plane lying for instance perpendicular to the lateral edge of the die, the n-well can be embedded to all sides in the p-region, namely towards the lateral edge and towards the active region, and also vertically downwards. The n-well can for instance reduce a blocking or reverse voltage towards the lateral edge of the die, e. g. reduce a backside potential reaching up to the frontside. Under the stress test conditions mentioned above, the n-well can form a source or drain region of the parasitic device, and the n-channel critical in view of the sodium diffusion can be triggered in the p-region. The respectively other source or drain region of this parasitic device can for instance be formed by a body region of the p-channel device in the active region or by an n-doped region between the active region and the edge termination structure, e. g. of an inactive cell.

The p-doped region, in which the n-well is formed, can for instance be an epitaxial region, e. g. be formed in an epitaxial layer deposited onto a semiconductor substrate, see in detail above. The p-region can in particular extend into and across the active region of the die, wherein the source, body and drain region of the device can be embedded into the p-region there. Compared to the source and drain region of the p-channel device, the p-region can, though being of the same doping type, have for instance a lower doping concentration.

In an embodiment, the insulation layer groove is arranged on a lateral position between an inner lateral end of the n-well and the lateral edge of the die. The "inner lateral end" of the n-well is oriented towards the active region, it faces away from the lateral edge of the die. Seen in a vertical cross-section, the sectional plane perpendicular to the lateral edge of the die, the insulation layer groove can basically be arranged in any position between the inner lateral end of the n-well and the lateral edge of the die. In particular, however, it is arranged on a lateral position within the n-well, e. g. seen in the cross-sectional view between the inner and the outer lateral end of the n-well. The outer lateral end of the n-well faces away from the active region, namely towards the lateral edge of the die.

Generally, when a relative arrangement between the active region and the lateral edge of the die is described, the respective elements (e. g. insulation layer groove, n-well and the like) as arranged on the same side of the active region towards the same lateral edge are considered. In other words, this relates in particular to a cross-sectional view, the vertical sectional plane perpendicular to the respective edge of the die, wherein the elements as arranged on the same side of the active region, between the latter and the lateral edge are considered (e. g. not elements on one side of the active region compared to elements on the other side of the active region).

In an embodiment, an imide layer extends above the n-well, covering it upwards. In particular, the whole n-well can be covered by the imide layer, namely at each lateral position. Therein, "covering" shall not imply a contact, vertically in between e. g. the insulation layer and/or a conductor line as discussed below can be arranged.

In an embodiment, the insulation layer groove extends vertically into the semiconductor body, which can for instance enhance the barrier properties and/or allow for an additional functionality (contact formation, see below). In other words, a lower end of the insulation layer groove is arranged below a lower end of the insulation layer directly aside the insulation layer groove. Generally, the insulation layer groove can for instance have a depth, which is taken vertically from the upper end of the insulation directly aside the groove to the lower end of the groove, of at least 1 µm, 1.5 µm or 1.8 µm, a typical depth being for instance 2 µm, with possible upper limits of for instance not more than 5 µm, 4 µm or 3 µm.

In an embodiment, the diffusion barrier material is a metal. In particular, the metal arranged in the insulation layer groove can comprise a titanium, titanium nitride and/or tungsten layer, wherein this stack can for example have a thickness of at least 150 nm or 200 nm and not more than 450 nm or 400 nm. In particular, the layer stack can comprise a comparably thin Ti/TiN layer covered by a proportionally thicker W-layer.

In an embodiment, a conductor line is arranged above the insulation layer groove and in particular made of an aluminum material, e. g. AlCu. The aforementioned diffusion barrier layer or layer stack can also extend outside of the insulation layer groove below the conductor line, e. g. serving as a diffusion barrier. Independently of these details, the conductor line can serve as an electrical contact to the n-well, e. g. for applying a potential to the n-well to reduce the blocking voltage towards the lateral edge of the die, see above. Consequently, the insulation layer groove extending around the active region can not only prevent a parasitic device formation but is also used for wiring, which can be advantageous in view of process integration or area consumption.

In an embodiment, the conductor line extends above the inner lateral end of the n-well and covers this inner lateral end upwards. Seen in a vertical cross-section perpendicular to the lateral edge of the die, the conductor line is arranged above this inner lateral end; seen in a vertical top view, the conductor line can extend in parallel to the inner lateral end of the n-well around the active region.

In an embodiment, the conductor line has a lateral width of 5 µm at minimum, further lower limits being 7 µm or 9 µm. Upper limits can for example be 30 µm or 15 µm, wherein the width is generally taken as the smallest lateral extension of the conductor line and on a vertical height of its lower end. In case of the conductor line extending in parallel to the lateral edge of the die, the width is taken perpendicularly to the lateral edge.

In an embodiment, an additional conductor line serving as a gate runner is arranged laterally between the conductor line and the active region. Seen in a vertical top view, the gate runner can extend to some extent, but not necessarily over the whole circumference around the active region, it can for instance have a U-shape. In particular, the gate runner can have basically the same lateral width like the conductor line discussed above; a lateral distance between these conductor lines can for instance be at least 5 µm or 8 µm and for example not more than 20 µm or 17 µm. Even though or in case that the gate runner would be critical in view of a parasitic device due to its position between the conductor line / n-well and the active region, this lateral position is "shielded" from sodium by the sodium stopper arranged laterally outside of the gate runner.

In an embodiment, the insulation layer comprises a borophosphosilicate glass (BPSG), in particular a BPSG layer on an undoped silicon glass (USG) layer.

The application relates also to a method of manufacturing a semiconductor die described here, wherein the insulation layer is deposited onto the semiconductor body and the insulation layer groove is etched into the insulation layer. Regarding further possible process steps, reference is made to the description above. The method can in particular comprise the device formation, e. g. the deposition of an epitaxial layer onto a semiconductor substrate and/or the formation of doped regions in the semiconductor body, for instance source, drain and body region.

### BRIEF DESCRIPTION OF THE DRAWINGS

Below, the semiconductor die is explained in further detail by means of exemplary embodiments. Therein, the individual features can also be relevant for the disclosure in a different combination.
- Figure 1: shows a portion of the die in a cross-sectional view;
- Figure 2: shows a detailed view of a sodium stopper formed in the die of figure 1;
- Figure 3: shows the die of figure 1 with an additional imide layer;
- Figure 4: shows an embodiment not within the scope of claim 1 to illustrate a parasitic device formation by sodium diffusion;
- Figure 5: shows a schematic view of a p-channel device formed in the active region of the die;
- Figure 6: summarizes some manufacturing steps in a flow diagram.

### DETAILED DESCRIPTION

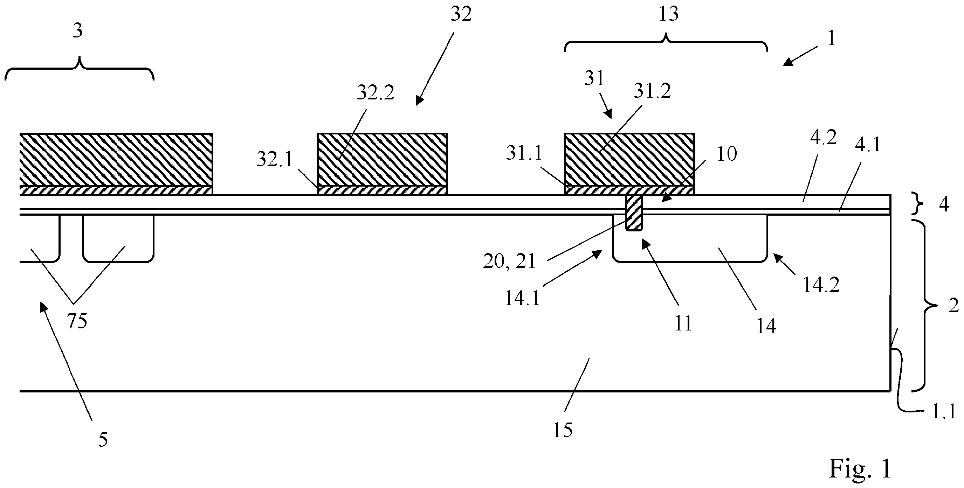

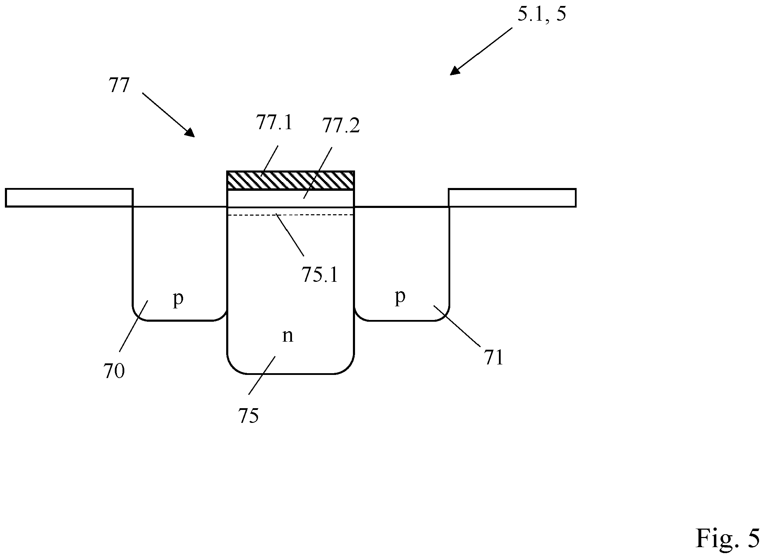

Figure 1 shows a sectional view of a semiconductor die 1 which comprises a semiconductor body 2. In an active region 3 of the semiconductor body 2, a p-channel device 5 is formed (not shown here, see figure 5 for details). On the semiconductor body 2, an insulation layer 4 is arranged, which comprises an USG layer 4.1 and a BPSG layer 4.2. To reduce a blocking or reverse voltage to the lateral edge 1.1 of the die 1, an edge termination structure 13 comprises an n-well 14 formed in the p-region 15.

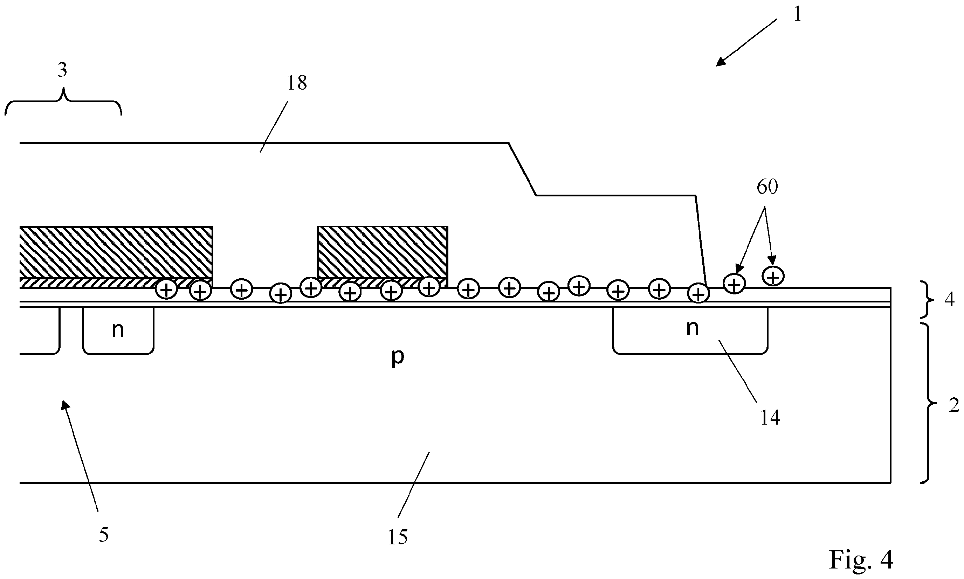

As discussed in detail below with reference to figure 4, the inventors found that an in-diffusion of sodium can create a parasitic device with the n-well 14 being a load terminal. To prevent such a parasitic device, an insulation layer groove 11 intersects the insulation layer 4 and is filled with a diffusion barrier material 21 to form a sodium stopper 10. Perpendicular to the drawing plane, the sodium stopper 10 extends continuously, it surrounds the active region 3 completely and forms a closed line. With the sodium stopper 10, a path for the sodium diffusion in the insulation layer 4 is interrupted.

In the example shown, the diffusion barrier material 21 is a metal 20, namely tungsten. Above the insulation layer groove 11, a conductor line 31 is formed, which is made of a tungsten layer 31.1 deposited when the sodium stopper groove 11 is filled and an aluminum layer 31.2. In between this conductor line 31 and the active region 3, an additional conductor line 32 is formed, which comprises also a tungsten layer 32.1 and an aluminum layer 32.2 on top. The additional conductor line 32 serves as a gate runner, namely for contacting the gate regions of the device cells in the active region 3, wherein contact details like a polysilicon layer extending from the additional conductor line 32 into the active region 3 and the like are not shown here.

The insulation layer groove 11 is arranged on a lateral position within the n-well, namely laterally between an inner lateral end 14.1 and an outer lateral end 14.2 of the n-well 14. In addition, the conductor line 31 covers the inner lateral end 14.1 upwards.

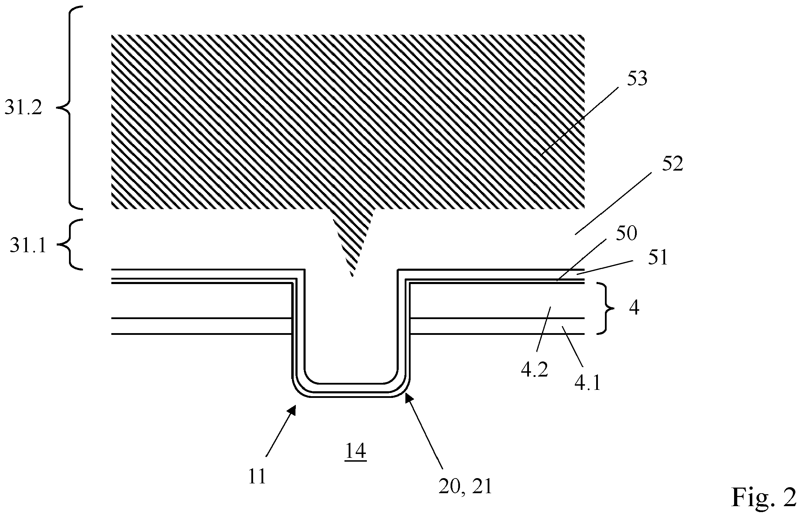

Figure 2 illustrates the insulation layer groove 11 and the metal/diffusion barrier material 20, 21 in a detailed view. The metal layer stack filling the insulation layer groove 11 and extending laterally aside comprises a titanium layer 50, a titanium nitride layer 51 and a tungsten layer 52. The tungsten layer 52 has a thickness of around 300 nm and fills the insulation layer groove 11 widely. On top, an aluminum layer 35 is arranged, which forms the conductor lines 30, 31 and also the metallization in the active region. Depending on the width of the insulation layer groove 11, the aluminum can also extend proportionately down into the groove, as illustrated schematically here. Above the n-well 14, the insulation layer 4 is composed of the USG and BPSG layer 4.1, 4.2 as discussed above. In other regions of the die, the insulation layer can additionally comprise a field and/or gate oxide.

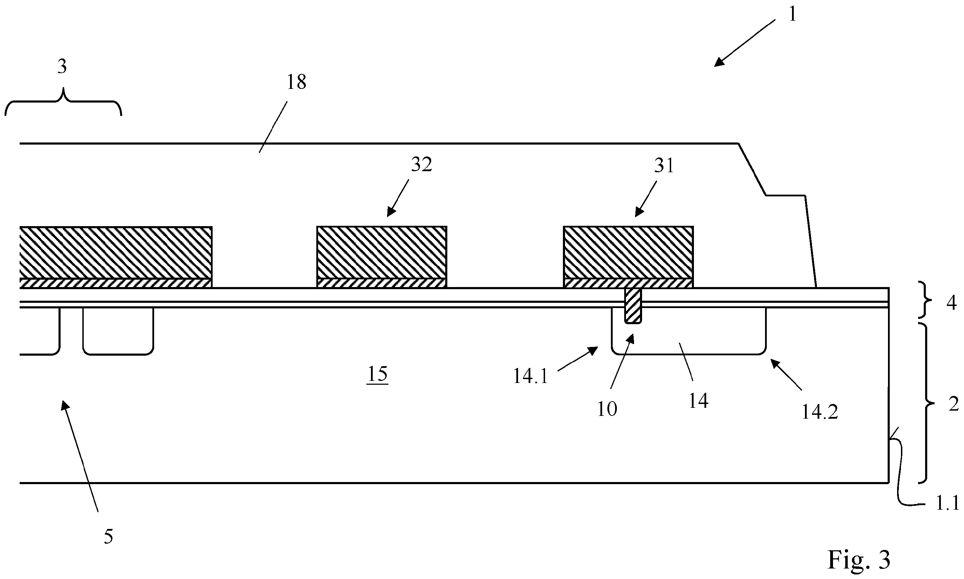

Figure 3 shows the same sectional view as figure 1, wherein like in figure 1 the illustration of the insulation layer 4 is simplified (without field/gate oxide in the region of the gate runner). In addition to the sodium stopper 10 interrupting an ion diffusion in the insulation layer 4, an imide layer 18 is deposited on top and covers the whole n-well 14 upwards. The imide layer 18 extends laterally towards the lateral edge 1.1 and in particular above the outer lateral end 14.2 of the n-well 14.

For comparison and illustration, figure 4 illustrates a die 1 without a sodium stopper. Even though the device 5 is a p-channel device (see below), the diffusion of sodium ions 60 in the insulation layer 4 can be critical. This is because the sodium ions 60 can create a parasitic n-channel device, one of its load terminals being the n-well 14 and the other one being an n-region of the device 5 or at the edge of the active region 3 (indicated with "n" in figure 4). In the p-region 15 in between, an n-channel can be triggered e. g. under HTRB or H3TRB conditions.

Figure 5 shows a schematic view of a device cell 5.1 of the p-channel device 5 formed in the active region. It comprises a source region 70, a drain region 71, both p-type, and an n-doped body region 75 in which the formation of a p-channel 75.1 can be triggered. For that purpose, a gate region 77 with a gate electrode 77.1 and gate dielectric 77.2 is arranged on top, the latter capacitively coupling the gate electrode 77.1 to the body region 75. The gate electrode 77.1 is electrically connected to the gate runner, namely the conductor line 32 (see figure 1, the connection is not shown). For illustration, the body region 75 is also referenced in figure 1.

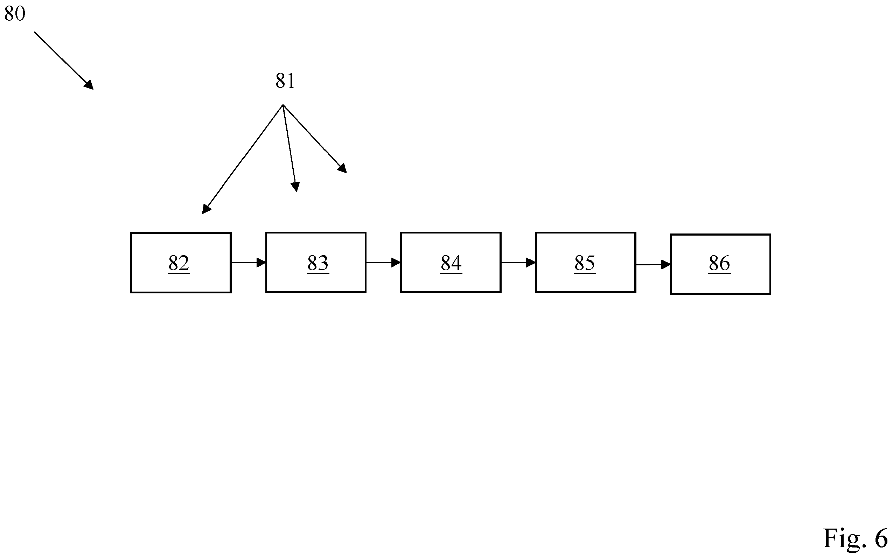

Figure 6 summarizes some manufacturing steps 81 in a flow diagram 80. After forming 82 the device in the active region, the insulation layer is deposited 83 onto the semiconductor body. Thereafter, the insulation layer groove 11 is etched 84 and filled 85 with the diffusion barrier material. Subsequently, the conductor lines can be formed 86.

## Claims

1. A semiconductor die (1), having
a semiconductor body (2) comprising an active region (3),
an insulation layer (4) formed on the semiconductor body (2),
wherein a p-channel device (5) is formed in the active region (3),
and wherein a sodium stopper (10) is formed in the insulation layer (4) and arranged laterally between the active region (3) and a lateral edge (1.1) of the die (1),
the sodium stopper (10) comprising an insulation layer groove (11), which intersects the insulation layer (4) vertically and extends around the active region (3), the insulation layer groove (11) filled with a diffusion barrier material (21).

2. The semiconductor die (1) of claim 1, wherein an edge termination structure (13) formed between the active region (3) and the lateral edge (1.1) of the die (1) comprises an n-well (14) in a p-region (15).

3. The semiconductor die (1) of claim 2, wherein the insulation layer groove (11) is arranged on a lateral position between an inner lateral end (14.1) of the n-well (14) and the lateral edge (1.1) of the die (1).

4. The semiconductor die (1) of claim 2 or 3, wherein the insulation layer groove (11) is arranged on a lateral position within the n-well (14).

5. The semiconductor die (1) of any one of claims 2 to 4, wherein an imide layer (18) extends above the n-well (14), covering the whole n-well (14) upwards

6. The semiconductor die (1) of any one of the preceding claims, wherein the insulation layer groove (11) extends vertically into the semiconductor body (2).

7. The semiconductor die (1) of any one of the preceding claims, wherein the diffusion barrier material (21) is a metal (20).

8. The semiconductor die (1) of claim 7, wherein the metal (20) arranged in the insulation layer groove (11) comprises at least one of a Ti, TiN and W layer (50, 51, 52).

9. The semiconductor die (1) of claim 7 or 8, wherein a conductor line (31) is arranged above the insulation layer groove (11) and in particular made of an aluminum material.

10. The semiconductor die (1) of claim 9 in combination with one of claims 2 to 5, wherein the conductor line (31) extends above an inner lateral end (14.1) of the n-well (14), covering this inner lateral end (14.1) upwards.

11. The semiconductor die (1) of claim 9 or 10, wherein the conductor line (31) has a lateral width of 5 µm at minimum.

12. The semiconductor die (1) of any one of claims 9 to 11, wherein an additional conductor line (32) serving as a gate runner is arranged laterally between the conductor line (31) and the active region (3).

13. The semiconductor die (1) of any one of the preceding claims, wherein the insulation layer (4) comprises a BPSG layer.

14. A method for manufacturing the semiconductor die (1) of any one of the preceding claims, comprising the steps (81):
i) depositing (83) the insulation layer (4) onto the semiconductor body (2);
ii) etching the insulation layer groove (11) into the insulation layer (4).

## Amended claims

### Amended claims in accordance with Rule 137(2) EPC.

1. A semiconductor die (1), having
a semiconductor body (2) comprising an active region (3),
an insulation layer (4) formed on the semiconductor body (2),
wherein a p-channel device (5) is formed in the active region (3),
and wherein a sodium stopper (10) is formed in the insulation layer (4) and arranged laterally between the active region (3) and a lateral edge (1.1) of the die (1),
the sodium stopper (10) comprising an insulation layer groove (11), which intersects the insulation layer (4) vertically and extends around the active region (3), the insulation layer groove (11) filled with a diffusion barrier material (21) for preventing a sodium diffusion in the insulation layer (4),
wherein an edge termination structure (13) formed between the active region (3) and the lateral edge (1.1) of the die (1) comprises an n-well (14) in a p-region (15).

2. The semiconductor die (1) of claim 1, wherein the insulation layer groove (11) is arranged on a lateral position between an inner lateral end (14.1) of the n-well (14) and the lateral edge (1.1) of the die (1).

3. The semiconductor die (1) of claim 1 or 2, wherein the insulation layer groove (11) is arranged on a lateral position within the n-well (14).

4. The semiconductor die (1) of any one of claims 1 to 3, wherein an imide layer (18) extends above the n-well (14), covering the whole n-well (14) upwards

5. The semiconductor die (1) of any one of the preceding claims, wherein the insulation layer groove (11) extends vertically into the semiconductor body (2).

6. The semiconductor die (1) of any one of the preceding claims, wherein the diffusion barrier material (21) is a metal (20).

7. The semiconductor die (1) of claim 6, wherein the metal (20) arranged in the insulation layer groove (11) comprises at least one of a Ti, TiN and W layer (50, 51, 52).

8. The semiconductor die (1) of claim 6 or 7, wherein a conductor line (31) is arranged above the insulation layer groove (11) and in particular made of an aluminum material.

9. The semiconductor die (1) of claim 8 in combination with one of claims 1 to 4, wherein the conductor line (31) extends above an inner lateral end (14.1) of the n-well (14), covering this inner lateral end (14.1) upwards.

10. The semiconductor die (1) of claim 8 or 9, wherein the conductor line (31) has a lateral width of 5 µm at minimum.

11. The semiconductor die (1) of any one of claims 8 to 10, wherein an additional conductor line (32) serving as a gate runner is arranged laterally between the conductor line (31) and the active region (3).

12. The semiconductor die (1) of any one of the preceding claims, wherein the insulation layer (4) comprises a BPSG layer.

13. A method for manufacturing the semiconductor die (1) of any one of the preceding claims, comprising the steps (81):
i) depositing (83) the insulation layer (4) onto the semiconductor body (2);
ii) etching the insulation layer groove (11) into the insulation layer (4).
